# EUROPEAN PATENT APPLICATION

(11) **EP 4 765 172 A1**
(43) Date of publication of application: **24.06.2026**
(21) Application number: 25218640.8
(22) Date of filing: 26.11.2025
(51) Int. Cl.: H01F 27/22, H01F 27/28

(54) **HEAT SPREADER**

(30) Priority: 26.11.2024 US 202463725124 P
(71) Applicant: Solaredge Technologies Ltd., Herzeliya 4673335 (IL)
(72) Inventor: KARIV, Tal, 4673335 Herzeliya (IL); AVIZRAT, Jeremy, 4673335 Herzeliya (IL); ELIYA, Tal, 4673335 Herzeliya (IL); BAGATURIA, Alexander, 4673335 Herzeliya (IL); VALDMAN, Adi, 4673335 Herzeliya (IL)
(74) Representative: V.O.

(57) **Abstract**

A heat spreader for an electrical component or components that may include a first surface and one or more cooling fins. The first surface may be configured to be connected to a second surface at a first side of the first surface. The cooling fin(s) may be connected (e.g., perpendicularly connected) to the first surface at a second side of the first surface. The cooling fin(s) may be configured to be thermally coupled to the electrical component or components, which are located at the second side of the first surface. The cooling fin(s) may conduct heat from the electrical component to the first surface.

## Description

### CROSS REFERENCE TO RELATED APPLICATIONS

This patent application claims priority to, and the benefit of, U.S. Provisional Patent Application No. 63/725,124, filed November 26, 2024, entitled "Heat Spreader," which is incorporated herein by reference in its entirety.

### FIELD OF THE DISCLOSURE

The disclosure relates generally to dissipating heat of electrical components. More specifically, the disclosure provides a heat spreader for conducting heat from one or more electrical components to a heatsink.

### BACKGROUND OF THE DISCLOSURE

An electrical component, operating in an electrical circuit, may generate heat during the operation of the electrical component. The heat generated by the electrical component may affect the temperature of the electrical component, which may, in turn, affect the performance and/or characteristics of the electrical component. For example, the resistance of a resistor may increase with temperature. The inductance of an inductor may increase with temperature. The capacitance of a capacitor may also vary with temperature. Therefore, electrical circuits may be connected to heatsinks which dissipate the heat and maintain the temperature of the electrical components within a determined range.

### BRIEF SUMMARY OF THE DISCLOSURE

The following presents a simplified summary of the disclosure in order to provide a basic understanding of some aspects of the disclosure. This summary is not an extensive overview of the disclosure. It is not intended to identify key or critical elements of the disclosure or to delineate the scope of the disclosure. The following summary merely presents some concepts of the disclosure in a simplified form as a prelude to the more detailed description provided below.

An aspect of the disclosure provides heat spreader for conducting heat from electrical components toward a heatsink. The heat spreader may include a surface and cooling fins, where the cooling fins are perpendicularly connected to the surface at one side of the surface. The cooling fins may be thermally coupled to one or more electrical components (e.g., resistors, capacitors, coils), where the one or more electrical components may be located at the one side of the surface. The heat spreader may be connected to a second surface, at another side of the surface of the heat spreader. The second surface may be thermally coupled to a heatsink, which may dissipate the heat generated by the one or more electrical components.

### BRIEF DESCRIPTION OF THE DRAWINGS

A more complete understanding of the present disclosure and the advantages thereof may be acquired by referring to the following description in consideration of the accompanying drawings, in which like reference numbers indicate like features, and wherein:
Figure 1A shows an apparatus which includes a heat spreader according to the disclosure herein;
Figures 1B-1D show examples of a heat spreader according to the disclosure herein;
Figures 1E and 1F show examples of cooling fins in a heat spreader according to the disclosure herein;
Figure 1G shows an example of a heat spreader attached to a heatsink according to the disclosure herein;
Figures 2A and 2B show an isometric view of an apparatus which includes a heat spreader according to the disclosure herein; and
Figure 3 shows an example of multiple heat spreaders thermally coupled to a heatsink.

### DETAILED DESCRIPTION OF THE DISCLOSURE

In the following description of the various embodiments, reference is made to the accompanying drawings, which form a part hereof, and in which is shown by way of illustration various embodiments in which the disclosure may be practiced. It is to be understood that other embodiments may be utilized and structural and functional modifications may be made without departing from the scope of the present disclosure.

The disclosure herein, describes a heat spreader for conducing heat from electrical components toward a heatsink. The heat spreader may include a surface and cooling fins, where the cooling fins are connected (e.g., perpendicularly connected) to the surface at one side of the surface. For example, the cooling fins may project or upstand from the surface at one side of the surface. The cooling fins may be thermally coupled to one or more electrical components (e.g., resistors, capacitors, coils), where the one or more electrical components may be located at the one side of the surface. The cooling fins and the surface may be configured to conduct heat from the one or more electrical components toward the heatsink. The heat spreader may be connected to a second surface at another side of the surface, where this second surface may be a cooling plate. The cooling plate may be thermally coupled to a heatsink which may dissipate the heat generated by the one or more electrical components.

A heat spreader according to the disclosure herein, may increase the interface area of the electrical component with the cooling apparatus and thus, may improve heat dissipation. An increased interface area of the electrical component with the cooling apparatus may reduce mechanical pressing requirement and reduce a thickness of a thermal paste (e.g., in cases in which such a paste may be used). In some instances, because of the improved heat dissipation, active cooling (e.g., using a fan) may be unnecessary.

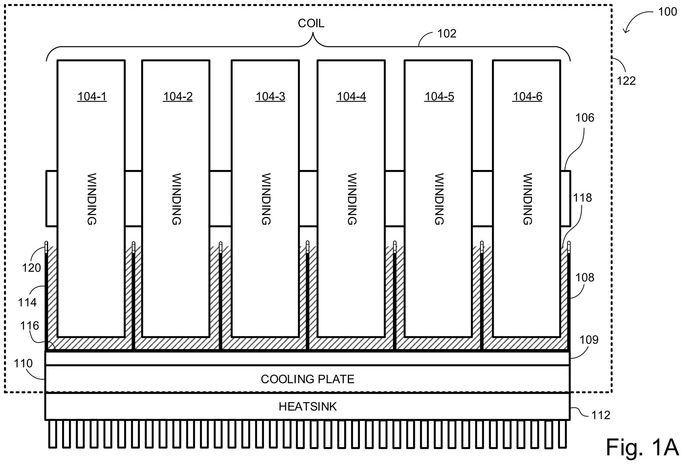

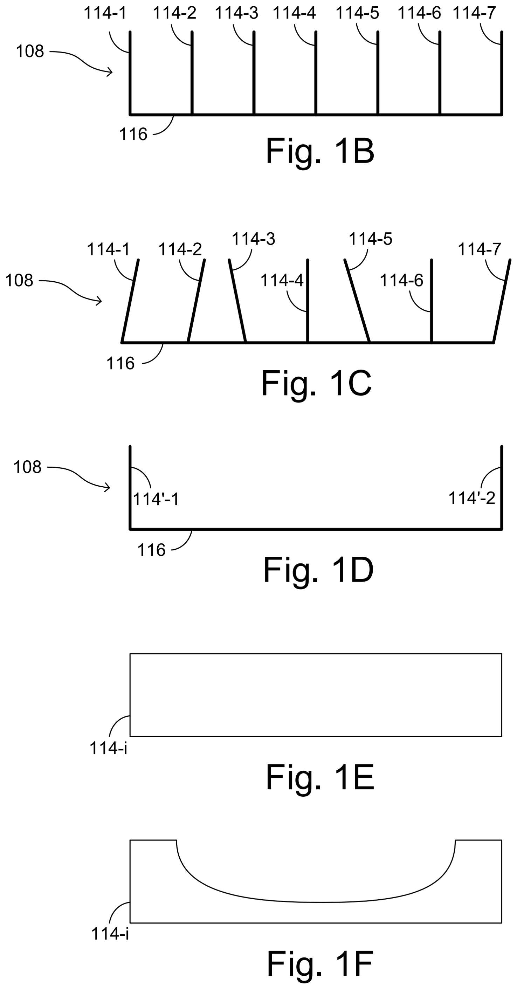

Reference is made to Figures 1A-1F, which show an apparatus, generally referenced 100, according to the disclosure herein, and aspects of apparatus 100. It is noted that for the sake of the clarity of the figures, not all reference numerals are shown in all the figures. Apparatus 100 may be an example of an apparatus for conducting heat from a coil, such as coil 102, to a heatsink, such as heatsink 112. Apparatus 100 may comprise a heat spreader 108, an electrically insulating and thermally conducting layer 109, a cooling plate 110, and a heatsink 112. Heat spreader 108 may comprise a surface 116, and one or more cooling fins 114 (e.g., cooling fins 114-1 to 114-7 in Figures 1B and 1C, cooling fins 114'-1 and 114'-2 in Figure 1D), connected to one side of surface 116. As shown in Figure 1B and 1D, cooling fins 114 may project outwardly from, and be perpendicularly connected to, the one side of surface 116. As shown in Figure 1C cooling fins 114 may project outwardly from, and be connected to, the one side of surface 116 at a corresponding angle. Heat spreader 108 may be made of an electrical and heat conducting material (e.g., using a metal such as aluminum or beryllium copper), and coated with an electrically insulating and thermally conducting material (e.g., coated with a polymer or with ceramic). Using beryllium copper may provide cooling fins 114 with increased flexibility relative to using aluminum. According to another example, heat spreader 108 may be made using carbon paper and support structure, where the support structure may be made of an electrically insulating and thermally conducting material, or may be made entirely of carbon. Heat spreader 108 may be made of an electrically insulating and thermally conducting material (e.g., a polymer, or a dielectric material such as ceramic), which may reduce the effects of heat spreader 108 on electromagnetic interference.

Heat spreader 108 may be connected to electrically insulating and thermally conducting layer 109 at another side of surface 116. Electrically insulating and thermally conducting layer 109 may be made from a polymer (e.g., Polyethylene Terephthalate), or ceramics, and may be constructed in layers of the same or different materials. According to the disclosure herein, electrically insulating and thermally conducting layer 109 may be integrated with heat spreader 108 (e.g., by using anodized sulfuric coating). Cooling plate 110 may be connected to electrically insulating and thermally conducting layer 109 and to heatsink 112. Heat spreader 108 and layer 109 may be connected to cooling plate 110 by solder, by glue, with screws and the like. Cooling plate 110 may be connected to heatsink 112 by solder, by glue, with screws and the like. Some or all of heat spreader 108, layer 109, cooling plate 110 and heatsink 112 may be integrated together. For example, heat spreader 108, layer 109, cooling plate 110 may be integrated in an insulated metal substrate printed circuit board (IMS PCB), where coil 102 may then be placed on heat spreader 108, and the IMS PCB may be coupled to heatsink 112. In such cases, heat spreader 108 may provide mechanical support of the coil 102.

One or more cooling fins 114 may be connected to one or more electrical components such as a coil, a resistor, or a capacitor. Figure 1A shows an example where the electrical component is a coil 102. Coil 102 may include a plurality of windings 104-1 to 104-6, wound around a core 106. As shown in Figure 1A, cooling fins 114-1 to 114-7 may have thermal contact with a pair of adjacent windings in coil 102. For example, cooling fin 114-2 may be in thermal contact with winding 102-1 and with winding 102-2. Cooling fin 114-3 may be in thermal contact with winding 102-2 and with winding 102-3. Thus, fins 114-1 to 114-7 may conduct heat from windings 104-1 to 104-6, to surface 116. Surface 116 may conduct heat from the fins 114-1 to 114-7, through electrically insulating and thermally conducting layer 109, to cooling plate 110. Cooling plate 110 may conduct heat to heat spreader 112, which may dissipate the heat. As shown in Figure 1A, heat spreader 108, electrically insulating thermally conducting layer 109, and cooling plate110 may be located within a housing 122. Heatsink 112 may be located outside housing 122. In some cases, housing 122 may be sealed from the environment thus preventing flow of air around coil 102. Thus, heat spreader 108 may conduct the heat generated in coil 102 toward heatsink 112, which may dissipate the heat generated by coil 102 to the environment.

Reference is made to Figures 1B-1D, which show examples of heat spreader 108. As mentioned above, in the example of Figure 1B, heat spreader 108 includes a plurality of cooling fins 114-1 to 114-7, perpendicularly connected to surface 116, where an electrical component may be placed between adjacent pairs of cooling fins 114-1 to 114-7. As mentioned above, each of cooling fins 114-1 to 114-7 may project outwardly from, and be connected to, surface 116 at a corresponding angle. In the example shown in Figure 1D, heat spreader 108 may include two cooling fins 114'-1 and 114'-2, perpendicularly connected to the one side of surface 116 at each end of surface 116. Thus, cooling fin 114'-1 may be thermally coupled to winding 104-1 and cooling fin 114'-2 may be thermally coupled to winding 104-6. The example of heat spreader 108 shown in Figure 1D may be used with a coil in which it may not be feasible to insert fins between the windings (e.g., due to the size of the coil), or with coils that require less heat dissipation. Reference is made to Figures 1E and 1F which show examples of a cooling fin 114-i, according to the disclosure herein. In Figure 1E cooling fin 114-i may have a rectangular shape. In Figure 1F cooling fin 114-i may have a convex shape. Referring back to Figure 1A, electrical insulating and thermally conducting material 118 may be placed between heat spreader 108 and the electrical component, for example, to increase the interface area with the electrical component with cooling fins 114-1 to 114-7, and reduce the required mechanical pressing tolerances (e.g., relative to when no such material is used). For example, the electrical insulating and thermally conducting material may be, an interstitial fluid 118 (e.g., thermal paste, or air) which may be deposited between cooling fins 114-1 to 114-7 and the one side of surface 116, and windings 104-1 to 104-6. Alternatively, the electrical insulating and thermally conducting material may be a solidifying composite material (e.g., epoxy resin) which may be deposited between cooling fins 114-1 to 114-7 and the one side of surface 116, and windings 104-1 to 104-6. Optionally, thermal pads or gap fillers (e.g., made of polymers) may be used as electrical insulating and thermally conducting material 118.

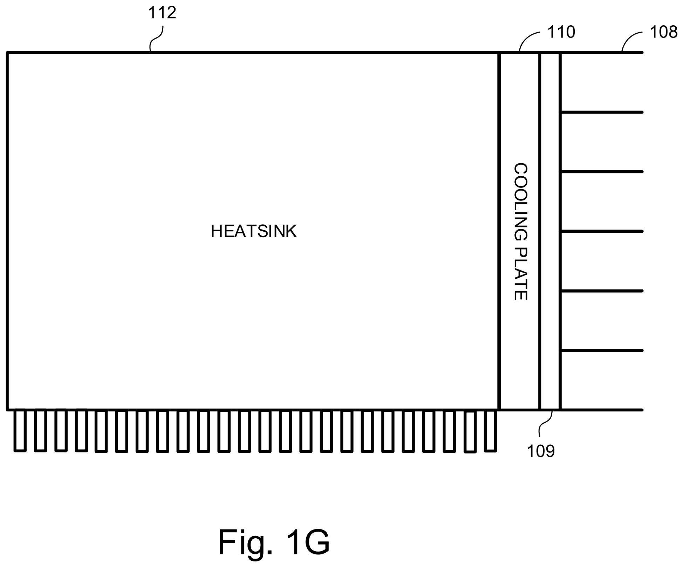

In some instances, mechanical constraints may prevent coupling heat spreader 108 to heatsink 112 as shown in Figure 1A. Therefore, and referring to Figure 1G, heat spreader 108 may be attached to heatsink 112 perpendicularly.

According to the disclosure herein, in cases in which the electrical component is a coil, heat spreader may include winding parters, such as winding parter 120 in Figure 1A. Winding parter 120 may be located at the sections of at least the cooling fins 114 that are inserted between the windings 104 of the coil 102 (e.g., cooling fins 114-2 to 114-5). However, all of cooling fins 114-1 to 114-7 may include a winding parter such as winding parter 120. Winding parter 120 may be made of a softer material (e.g., a polymer) than windings 104. Thus, when fins 114-1 to 114-7 are inserted between windings 104, winding parter 120 may spread the windings 104 apart, thus avoiding scratching windings 104 and eroding the electrically insulating material which coats the windings 104. To add the softer material, the top part of cooling fins 114 may be coated by the polymer (e.g., dipped in the polymer, which may then be cured).

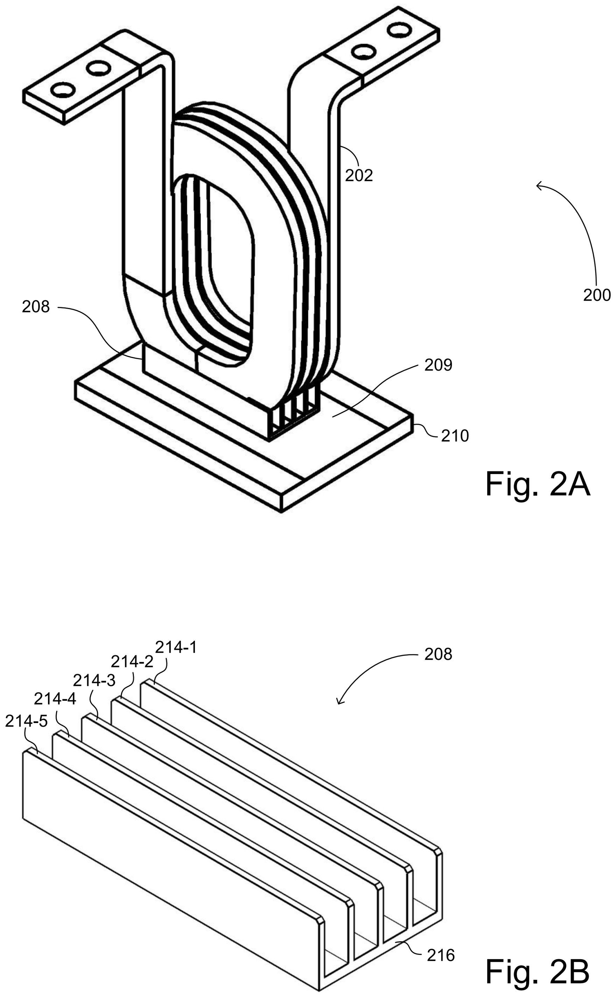

Reference is made to Figures 2A and 2B which show an isometric view of an apparatus 200 which may be similar to apparatus 100 (Figure 1A). Apparatus 200 may comprise a coil 202, a heat spreader 208, a cooling plate 210, and an electrically insulating and thermally conducting layer 209. Coil 202 may correspond to coil 102 (Figure 1A), heat spreader 208 may correspond to heat spreader 108 (Figures 1A, 1B, 1C, 1D, 1E, and 1F), and may include cooling fins 214-1 to 214-7, perpendicularly attached to a first side of surface 216. Cooling plate 210 may correspond to cooling plate 110 (Figure 1A), and electrically insulating and thermally conducting layer 209 may correspond to cooling plate electrically insulating and thermally conducting layer 109 (Figure 1A).

Similar to as shown in Figure 1A, in Figures 2A and 2B, cooling fins 214-1 to 214-7 may have thermal contact with a pair of adjacent windings in coil 202. Heat spreader 208 may be thermally coupled with cooling plate 110 via electrically insulating and thermally conducting layer 209. Thus, heat spreader 208 may conduct heat from coil 202 toward a heatsink (not shown in Figures 2A-2B), similar to heatsink 112 (Figure 1A).

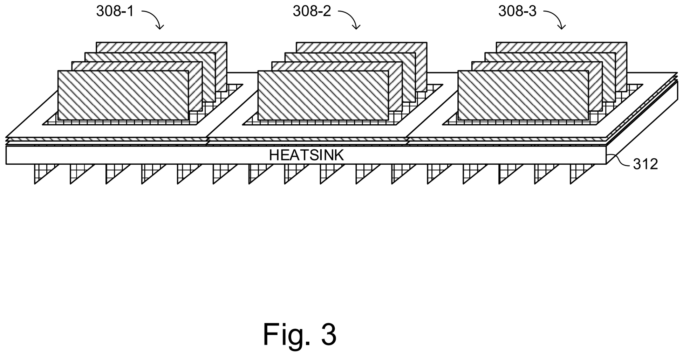

Figure 1A shows a single heat spreader 108 thermally coupled to heatsink 112. According to the disclosure herein, more than one heat spreader, such as heat spreader 108, may be coupled (e.g., thermally and mechanically) to heatsink 112 (e.g., via a common cooling plate or multiple cooling plates such as cooling plate 110). Reference is now made to Figure 3, which shows an example of three heat spreaders (heat spreader 308-1, heat spreader 308-2, and heat spreader 308-3) thermally coupled to heatsink 312. Each one of heat spreader 308-1, heat spreader 308-2, and heat spreader 308-3 may be similar to heat spreader 108 (Figures 1A-1F) or heat spreader 208 (Figures 2A and 2B). Heatsink 312 may be similar to heatsink 112 (Figure 1A). For example, heat spreader 308-1, heat spreader 308-2, and heat spreader 308-3 may be integrated in an insulated metal substrate printed circuit board (IMS PCB), where coils 102 may then be placed on heat spreaders heat spreader 308-1, 308-2, and 308-1, and the IMS PCB may be coupled to heatsink 312.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

Hereinafter, various characteristics will be highlighted in a set of numbered clauses or paragraphs. These characteristics are not to be interpreted as being limiting, but are provided merely as a highlighting of some characteristics as described herein, without suggesting a particular order of importance or relevancy of such characteristics.

Clause 1. An apparatus comprising: a first surface configured to be thermally coupled to a second surface at a first side of the first surface; and a cooling fin, perpendicularly connected to the first surface at a second side of the first surface, wherein the cooling fin is configured to be thermally coupled to an electrical component located at the second side of the first surface.

Clause 2. The apparatus of clause 1, wherein the electrical component is a coil, and wherein the cooling fin is configured to have thermal contact with a pair of adjacent windings of the coil.

Clause 3. The apparatus of clause 2, further comprising a second cooling fin configured to have thermal contact with a second pair of adjacent windings of the coil.

Clause 4. The apparatus of clause 1, wherein the electrical component is a coil, and wherein the cooling fin is configured to have thermal contact with a first winding of the coil at a first side of the cooling fin, and wherein the cooling fin is configured to have thermal contact with a second winding of the coil at a second side of the cooling fin.

Clause 5. The apparatus of clause 4, further comprising a second cooling fin configured to have thermal contact with a third winding of the coil at a first side of the second cooling fin, and wherein the second cooling fin is configured to have thermal contact with a further winding of the coil at a second side of the cooling fin.

Clause 6. The apparatus of any of clauses 1-5, wherein the second surface is a cooling plate.

Clause 7. The apparatus of clause 6, wherein the first surface, the cooling fin, and the cooling plate are integrated in an insulated metal substrate printed circuit board (IMS PCB).

Clause 8. The apparatus of any of clauses 1-7, further comprising an electrical insulating layer between the first surface and the second surface.

Clause 9. The apparatus of clause 8, wherein the electrical insulating layer is thermally conductive.

Clause 10. The apparatus of clause 1, wherein the electrical component is a coil, and wherein the apparatus further comprises a second cooling fin, perpendicularly connected to the second side of the first surface, wherein the cooling fin is configured to be thermally coupled to a first winding at a first end of the coil, and the second cooling fin is configured to be thermally coupled to a second winding at a second end of the coil.

Clause 11. The apparatus of clause 10, further comprising a third cooling fin, perpendicularly connected to the first surface, wherein the third cooling fin is configured to be thermally coupled to the coil between a pair of adjacent windings of the coil.

Clause 12. The apparatus of any of clauses 1-11, further comprising an interstitial fluid deposited between the cooling fin and the first surface, and the electrical component.

Clause 13. The apparatus of clause 12, wherein the interstitial fluid is a thermal paste.

Clause 14. The apparatus of clause 12, wherein the interstitial fluid is air.

Clause 15. The apparatus of any of clauses 1-11, further comprising a thermal pad deposited between the cooling fin and the first surface, and the electrical component.

Clause 16. The apparatus of any of clauses 1-15, wherein the second surface is thermally coupled to a heatsink.

Clause 17. The apparatus of clause 16, further comprising: a third surface configured to be connected to a fourth surface at a first side of the third surface; and a second cooling fin, perpendicularly connected to the third surface at a second side of the third surface, wherein the second cooling fin is configured to be thermally coupled to a second electrical component located at the second side of the third surface, wherein the fourth surface is thermally coupled to the heatsink.

Clause 18. The apparatus of clause 1, wherein the electrical component is a resistor.

Clause 19. The apparatus of clause 1, wherein the electrical component is a capacitor.

Clause 20. The apparatus of any of clauses 1-19, wherein the cooling fin has a rectangular shape.

Clause 21. The apparatus of any of clauses 1-19, wherein the cooling fin has a convex shape.

Clause 22. The apparatus of clause 1, wherein the electrical component is a coil, wherein the cooling fin further comprises, at a section of the cooling fin that is inserted between windings of the coil, a winding parter, and wherein the winding parter is made of a softer material than the windings of the coil.

Clause 23. The apparatus of any of clauses 1-22, wherein the first surface and the cooling fin are made of an electrically insulating heat conducting material.

Clause 24. The apparatus of clause 23, wherein the electrically insulating heat conducting material is a polymer.

Clause 25. The apparatus of clause 23, wherein the electrically insulating heat conducting material is ceramic.

Clause 26. The apparatus of any of clauses 1-22, wherein the first surface and the cooling fin are made of an electrically and heat conducting material, wherein the first surface and the cooling fin are coated with an electrically insulating thermally conducting material.

Clause 27. The apparatus of clause 26, wherein the first surface and the cooling fin are made of aluminum.

Clause 28. The apparatus of clause 26, wherein the first surface and the cooling fin are made of beryllium copper.

Clause 29. An apparatus comprising: a coil comprising two or more windings; and a heat spreader comprising: a first surface configured to be connected to a second surface at a first side of the first surface; and a cooling fin, perpendicularly connected to the first surface at a second side of the first surface, wherein the cooling fin is configured to be thermally coupled to an electrical component located at the second side of the first surface.

Clause 30. An apparatus comprising: a first surface configured to be connected to a second surface at a first side of the first surface; and a cooling fin, connected to the first surface at a second side of the first surface, wherein the cooling fin is configured to be thermally coupled to an electrical component for conducting heat from the electrical component to the first surface.

Clause 31. An apparatus comprising: a first surface configured to be thermally coupled to a second surface at a first side of the first surface; and a cooling fin projecting from the first surface at a second side of the first surface, wherein the cooling fin is configured to be thermally coupled to an electrical component located at the second side of the first surface.

Clause 32. The apparatus of clause 31, wherein the cooling fin perpendicularly projects from the second side of the first surface.

Clause 33. An apparatus comprising: a first surface configured to be thermally coupled to a second surface at a first side of the first surface; and a cooling fin upstanding from the first surface at a second side of the first surface, wherein the cooling fin is configured to be thermally coupled to an electrical component located at the second side of the first surface.

Clause 34. The apparatus of clause 31, wherein the cooling fin is perpendicularly upstanding from the second side of the first surface.

## Claims

1. An apparatus comprising:
a first surface configured to be thermally coupled to a second surface at a first side of the first surface; and
a cooling fin, perpendicularly connected to the first surface at a second side of the first surface, wherein the cooling fin is configured to be thermally coupled to an electrical component located at the second side of the first surface.

2. The apparatus of claim 1, wherein the electrical component is a coil, and
wherein the cooling fin is configured to have thermal contact with a pair of adjacent windings of the coil.

3. The apparatus of claim 1, wherein the electrical component is a coil, and
wherein the cooling fin is configured to have thermal contact with a first winding of the coil at a first side of the cooling fin, and
wherein the cooling fin is configured to have thermal contact with a second winding of the coil at a second side of the cooling fin.

4. The apparatus of claim 3, further comprising a second cooling fin configured to have thermal contact with a third winding of the coil at a first side of the second cooling fin, and
wherein the second cooling fin is configured to have thermal contact with a further winding of the coil at a second side of the cooling fin.

5. The apparatus of any preceding claim, wherein the second surface is a cooling plate.

6. The apparatus of claim 5, wherein the first surface, the cooling fin, and the cooling plate are integrated in an insulated metal substrate printed circuit board (IMS PCB).

7. The apparatus of any preceding claim, further comprising an electrical insulating layer between the first surface and the second surface,
wherein the electrical insulating layer is thermally conductive.

8. The apparatus of claim 1, wherein the electrical component is a coil, and
wherein the apparatus further comprises a second cooling fin, perpendicularly connected to the second side of the first surface,
wherein the cooling fin is configured to be thermally coupled to a first winding at a first end of the coil, and the second cooling fin is configured to be thermally coupled to a second winding at a second end of the coil.

9. The apparatus of claim 8, further comprising a third cooling fin, perpendicularly connected to the first surface, wherein the third cooling fin is configured to be thermally coupled to the coil between a pair of adjacent windings of the coil.

10. The apparatus of any preceding claim, further comprises an interstitial fluid deposited between the cooling fin and the first surface, and the electrical component.

11. The apparatus of any preceding claim, further comprises a thermal pad deposited between the cooling fin and the first surface, and the electrical component.

12. The apparatus of any preceding claim, wherein the second surface is thermally coupled to a heatsink.

13. The apparatus of claim 12, further comprising:
a third surface configured to be connected to a fourth surface at a first side of the third surface; and
a second cooling fin, perpendicularly connected to the third surface at a second side of the third surface, wherein the second cooling fin is configured to be thermally coupled to a second electrical component located at the second side of the third surface,
wherein the fourth surface is thermally coupled to the heatsink.

14. The apparatus of claim 1, wherein the electrical component is a coil,
wherein the cooling fin further comprises, at a section of the cooling fin that is inserted between windings of the coil, a winding parter, and
wherein the winding parter is made of a softer material than the windings of the coil.

15. The apparatus of any preceding claim, wherein the first surface and the cooling fin are made of an electrically insulating heat conducting material.
